Europäisches Patentamt

(19) European Patent Office

Office européen des brevets

(11) Publication number: 0 109 825
A2

(12) EUROPEAN PATENT APPLICATION

(21) Application number: 83306996.6

(22) Date of filing: 16.11.83

(51) Int. Cl.³: H 05 K 13/04

(30) Priority: 22.11.82 US 443863

(43) Date of publication of application:
30.05.84 Bulletin 84/22

(84) Designated Contracting States:
AT BE CH DE FR GB IT LI LU NL SE

(71) Applicant: PLESSEY TELECOMMUNICATIONS AND
OFFICE SYSTEMS LIMITED
Vicarage Lane
Ilford Essex IG1 4AQ(GB)

(72) Inventor: Camuso, Joseph J.
P.O. Box 7000
Longwood Florida(US)

(74) Representative: Hart, Robert John
Plessey Telecommunications Limited Edge Lane
Liverpool L7 9NW(GB)

(54) Automatic device for clinching electronic components to printed circuit boards.

(57) A device for clinching electronic components mounted onto a printed circuit board to prevent them from becoming dislodged from the board before they can be soldered. A fixture plate supports a plurality of clinch blocks removably array in the pattern of in which the components are to be mounted on the board. The drilled and etched circuit board is supported above, and spaced apart from, the fixture plate and clinch blocks. An elevator raises the fixture plate until the clinch blocks are in juxtaposition below the circuit board. As each component is mounted onto the board, the leads extending through the board contact.the clinch blocks and are bent thereby in opposite directions. This prevents the leads from slipping out of the holes, clinching the components to the board. After all of the components are mounted onto the board, the elevator lowers the fixture plate and clinch blocks, allowing the board to be moved to the next manufacturing location.

FIG.I

Background of the Invention

Field of the Invention

This invention relates generally to the field of apparatus for mounting electronic components and the like having leads or wires extending therefrom onto printed circuit boards, and more particularly to an apparatus for crimping or bending the leads so as to clinch the components onto the board, thereby preventing them from becoming dislodged before they can be soldered to the board.

Description of the Prior Art

The use of printed circuit boards in fabricating electronic equipment has vastly increased the reliability, and greatly reduced the manufacturing cost, of electronic equipment. Prior to printed circuit boards, circuit components were required to be mounted into a chassis, and wires were connected between appropriate leads. Printed circuit boards, on the other hand, have holes drilled to receive the component leads, and the connections between appropriate leads are provided by metallic traces that are etched thereon by photographic and chemical processes. All that need be done is to mount the components onto the board by inserting the leads through the holes and soldering the leads to the pre-etched connections.

While components may be manually mounted onto a printed circuit board, this can be tedious and time consuming and is subject to error. A number of machines have been developed in the last few years to mount components onto a board. This has particularly come about since the development and standardization of the integrated circuit packages, most particularly "dual in-line packages" or "DIP's", which are available in standard sizes. In these machines, as exemplified in U.S. Patent No. 3,893,232, issued to Fletcher, et al, on July 8, 1975, and U.S. Patent No. 4,202,092, issued to Shibasaki, et al, on May 13, 1980, a robot arm picks up and mounts each component onto a printed circuit board, inserting the leads through the holes drilled in the board. As the leads are inserted through the holes, an anvil beneath the board rises to come into contact with the leads and bends them in opposite directions. This causes the leads to be displaced so that they cannot slip out of the holes in the board, thereby "clinching" the components to the board, preventing them from falling off of the board before they can be soldered to the board during a subsequent soldering step.

In the machines such as described in the aforementioned Fletcher, et al, and Shibasaki, et al, patents, there one anvil is provided for each robot arm. Either the anvil and robot arm move over the circuit board to mount the components in the appropriate locations, or the circuit board moves in relation to the robot arm and anvil to properly mount thecomponent onto the circuit board. Each time a component is mounted the anvil must be raised and lowered to bend the leads. Requiring the anvil to move as well as the robot arm requires control circuitry for the anvil, substantially adding to the cost of the assembly machine.

## Summary

It is therefore an object of the invention to provide a new and improved device for clinching electronic components onto a printed circuit board.

It is a further object of the invention to provide a new device for clinching the leads of an electronic component onto a printed circuit board at substantially reduced cost and with enhanced flexibility.

In brief, the invention provides a device used in connection with a robot that mounts electronic components onto a printed circuit board in a selected pattern. A fixture plate is positioned spaced below aprinted circuit board that has been drilled and etched and is ready to receive the components. The fixture plate carries a plurality of clinch blocks arrayed in apattern similar to the pattern in which the electronic components are to be mounted on the printed circuit board. An elevator is provided to raise and lower the fixture plate in relation to the printed circuit board.

When a printed circuit board is positioned above the fixture plate, the elevator raises the fixture plate until the clinch blocks are juxtaposed to the lower surface of the circuit board. As each circuit component is mounted onto the board, the component leads come into contact with the upper bearing surface of a clinch block. The clinch block bends the leads in opposite directions, thereby clinching the component to the printed circuit board and preventing it from becoming dislodged while other components are mounted and before they are soldered to the board. The elevator then lowers the fixture plate, retracting the clinch blocks and allowing the board to proceed to the next manufacturing step.

The pattern of the clinch blocks on the fixture plate may be varied in accordance with the pattern of the electronic components to be mounted on the printed circuit board. The clinch blocks are removably mounted on the fixture plate, and they may be moved by hand or by the robot arm prior to mounting the components on the circuit board. If each component has an associated clinch block, the same robot arm control may be used to mount the clinch blocks onto the fixture plate as is used to mount the components onto the circuit board, thus simplifying programming of the robot arm control. Furthermore, the same fixture plate and clinch blocks may used to clinch many different patterns of components to the circuit board with very fast modification.

## Brief Description of the Drawings

This invention is pointed out with particularity in the appended claims. The above and further objects and advantages of this invention may be better understood by referring to the following description taken in conjunction with the accompanying drawings, in which:

FIG. 1 is a side elevational view of an automatic device for clinching electronic components to printed circuit boards constructed in accordance with this invention;

FIG. 2 is a sectional drawing taken along lines 2-2 in FIG. 1; and

FIGS. 3A and 3B are detailed drawings useful in understanding the method of operation of the device shown in FIGS. 1 and 2.

Description of an Illustrative Embodiment

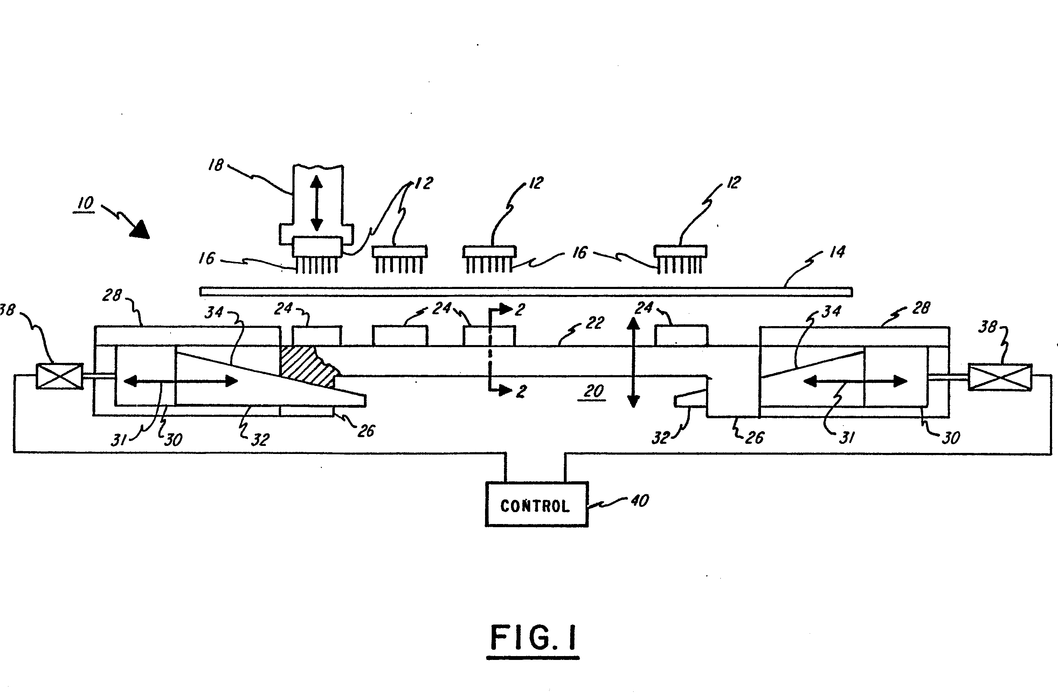

FIG. 1 depicts a device 10 for mounting a plurality of electronic components 12 onto a printed circuit board 14. The printed circuit board has been suitably drilled with holes (not shown) to receive leads 16, and etched with metallic traces (also not shown) in a manner that is well-known in the art and which forms no part of this invention. FIG. 1 particularly shows the mounting of integrated circuit modules that are packaged in dual in-line packages or "DIP's"; however, the invention may be used with electronic components that are not packaged in DIP's with suitable modification that will be apparent to those skilled in the art.

The components 12 are mounted onto the boards 14 by a robot arm 18, which retrieves components from a hopper (not shown) carries them to a position over the board, and lowers the component so that the leads project through the holes drilled in the printed circuit board 14. Suitable robot arms and control mechanisms therefor are known in the art, and are exemplified by the aforementioned Fletcher, et al, and Shibasaki, et al, patents.

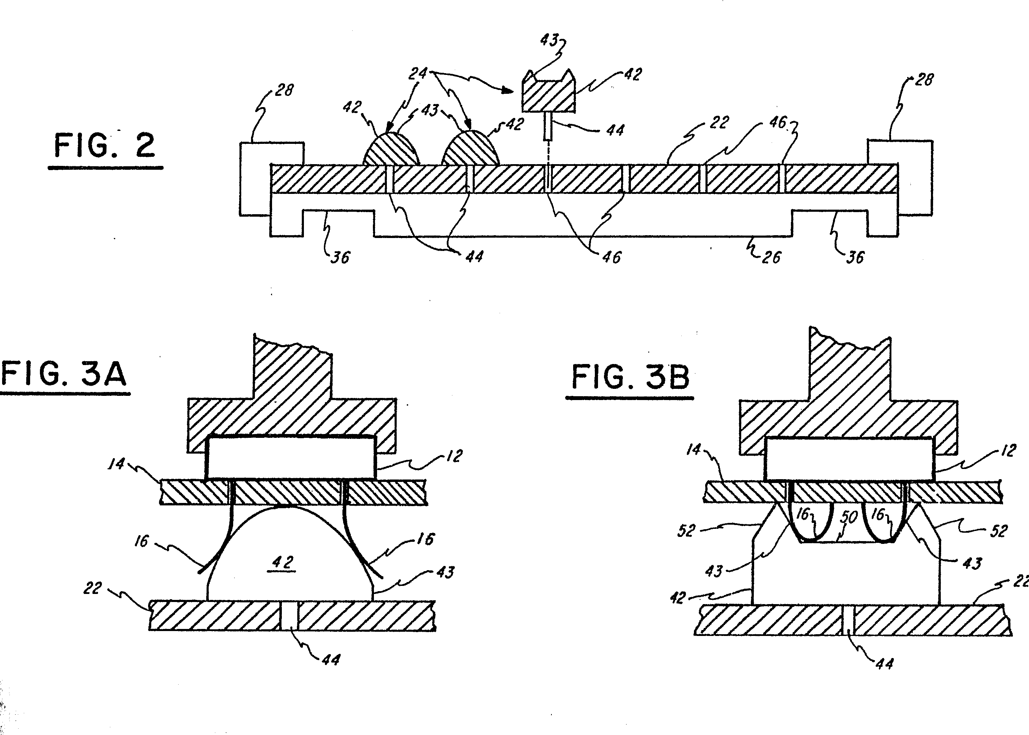

In accordance with the invention, a clinching device 20 is provided to bend the leads 16 of the electronic components 12 as they are inserted through the printed circuit board 14 to cause them to be retained in board 14 during subsequent manufactureing steps and before the components are soldered to the board. A fixture plate 22 carries a plurality of clinch blocks 24 arrayed in a pattern similar to the pattern in which the electronic components 12 are to be mounted on printed circuit board 14. At opposite ends of fixture plate 22 are downwardly depending flanges 26. Adjacent the flanges are guide members 28 which define a path for reciprocable elevator members 30. The elevator members have projecting nose members 32 having an incline surface 34 that extends under and through a slot 36 (also shown in FIG. 2) to support flanges 26 and fixture plate 22.

The elevator members 30 move in a path toward and away from each other according to the arrows 31 as defined by guide members 28. Particularly, the elevator members 30, when moved toward each other, project the nose members 32 further under fixture plate 22 as shown in FIG. 1, and causing the incline surfaces 34 to raise fixture plate 22. The elevator members 30 may also be moved farther apart, as shown in FIG 1, causing the nose members to be retracted from under and lowering fixture plate 22, in which case the fixture plate is lowered.

The clinching device 20 also includes a conventional hydraulic piston member 38 attached to each elevator member 30 under control of a control unit 40. The control unit operates to cause air pistons 38 to move the elevator members 30 to raise and lower fixture plate 22, thereby varying the spacing between fixture plate 22 and printed circuit board 14.

With particular reference to FIG. 2, the clinch blocks are removable from fixture plate 22, and include a body 42 that rests on and extends above the fixture plate and provides an upper bearing surface 43 that intercepts the leads 16 as they are inserted through printed circuit board 14 and bends them in opposite directions to clinch the component of the circuit board. Extending downwardly from each clinch block body is a post 44 that can be inserted into a mating hole 46 in the fixture plate 22. The clinch blocks may be arrayed in any pattern over the fixture plate as defined by the holes 46.

In operation, with particular reference to FIGS. 1 and 2, the clinch blocks are first mounted on fixture plate 22 in a pattern similar to the pattern in which the electronic components are to be mounted on the printed circuit boards. The pattern of clinch blocks on fixture plate 22 is selected to allow the bearing surfaces 43 to be in proper positions to intercept and bend the component leads when they are inserted through the circuit board. In many cases this pattern can be identical to the pattern in which the components are to be mounted on the circuit board 14.

Mounting the clinch blocks 24 onto fixture plate 22 may be done manually, or it may be done by the robot arm 18, with suitable modifications in the end of the robot arm to allow it to pick up and deposit the clinch blocks onto the fixture plate. The control 40 then actuates the hydraulic cylinders 38 forcing the elevators 30 together, thereby raising fixture plate 22 until the clinch blocks are in juxtaposition with and immediately below the printed circuit board 14. The robot arm 18 then mounts each electronic component 12 onto the printed circuit board 14 by inserting its leads 16 through the holes in the board 14. The leads of the electronic component come in contact with the bearing surfaces 43 of body 42 of clinch blocks 24, which cause them to bend in opposite directions thereby clinching the component to board 14. The robot arm 18 continues to mount the components onto board 14 in this manner, until all of the components have been mounted.

After all of the components have been mounted, control 40 causes hydraulic cylinders 38 to retract elevators 30 thereby lowering the fixture plate 22. The printed circuit board 14, with the electronic components mounted thereon, can then be sent to the next location for the next manufacturing step, which may typically be a soldering step in which the components leads are soldered to the traces on the circuit board.

FIGS. 3A and 3B depict two alternate forms of a body 42 for clinch blocks 24. Other forms are within the scope of the invention; the only requisite being that the bearing surface of the body be so configured as to divert and bend the leads 16 as they are inserted through printed circuit board 14 in opposite directions to prevent the component leads from slipping out of the holes. FIG. 3A depicts a clinch block having a rounded bearing surface 43, or semicircular cross-section. The leads 16 come in contact with the rounded surface of the body and are diverted in opposite directions outwardly.

The configuration depicted in FIG. 3B has a central flat surface 50 having humps 52 along opposite edges. Depending on the location of the humps 52 with respect to the component leads 16 when they are inserted through the circuit board 14, the clinch block 42 may divert the leads either outwardly, or inwardly as depicted in FIG. 3B. For components having short leads, the clinch block depicted in FIG. 3B, with the leads being diverted inwardly, may be preferable, whereas for components having relatively long leads, diverting the leads outwardly may be preferable.

Other configurations for the body 42 of clinch blocks 24 may also be envisioned. Furthermore, instead of using hydraulic cylinders 38 to move elevators 30 and raise an lower fixture plate 22, electrical elements such as solenoids or linear motors may be used.

The foregoing description is limited to a specific embodiment of this invention. It will be apparent, however, that this invention may be practiced in apparatus having diverse basic construction than is described in the specification with the attainment of some or all of the objects and advantages of this invention. Therefore, it is the object of the appended claims to cover all such variations and modifications as come within the true spirit and scope of this invention.

What is claimed as new and desired to be secured by Letters Patent of the United States is:

1. A clinch unit for use in an apparatus for mounting components onto a planar support member in a predetermined pattern, the components having bendable members for extending through apertures formed in said planar support member, the clinch unit comprising:

A. planar base means adapted to be located below and spaced apart from the planar support member;

B. a plurality of block means removably arrayed over the surface of said planar base means and supported thereby in fixed relation to the pattern in which the components are to be mounted onto the planar support member; and

C. elevator means for raising said planar base means toward the planar support member and then lowering said planar base means away from the planar support member when the components are mounted onto the planar support member, so that the block means intercept and bend the bendable members in opposite directions to clinch the components onto the planar support member and preventing them from becoming dislodged therefrom.

2. A clinch unit as defined in claim 1 wherein said elevator means includes means for raising and lowering said planar base means after each component is mounted onto the planar support member, to thereby clinch each component to the planar support member after it is mounted onto the planar support member.

3. A clinch unit as defined in claim 1 wherein the planar base means has means defining a plurality of apertures arrayed thereover, and each of said block means includes mating means for extending into at least one of said apertures to thereby hold said block means in fixed relation to a component mounted on the planar support member.

4. A clinch unit as defined in claim 1 wherein at least one block means has a semi-cylindrical face pointing toward the planar support member, so that when the planar base means is raised the semi-cylindrical face of said block means intercepts the bendable members and bends them to clinch the the component onto the planar support member.

5. A clinch unit as defined in claim 1 wherein said elevator means includes:

A. two opposing guide means situated on opposite sides of said planar base means;

B. incline means attached to each of said opposing guide means and including an incline surface extending beneath said planar base means; and

C. reciprocating means connected to both of said opposing guide means to move said opposing guide means together or apart simultaneously, moving the opposing guide means together causing the incline means to extend further beneath the planar base means thereby raising it, and moving the opposing guide means apart causing the incline means to retract from underneath the planar base means thereby lowering it.

FIG.1

0109825

FIG. 2

2/2

FIG. 3A

FIG. 3B

0109825